Europäisches Patentamt

(19) European Patent Office

Office européen des brevets

(11) Publication number: **0 011 556**
**B1**

(12) **EUROPEAN PATENT SPECIFICATION**

(45) Date de publication du fascicule du brevet: 08.06.83

(21) Numéro de dépôt: 79400844.1

(22) Date de dépôt: 09.11.79

(51) Int. Cl.³: **H 03 H 15/02,** H 01 L 27/10
//G 06 G 7/16

(54) Filtre à transfert de charges électriques, programmable numériquement.

(30) Priorité: 17.11.78 FR 7832538

(43) Date de publication de la demande:
28.05.80 Bulletin 80/11

(45) Mention de la délivrance du brevet:
08.06.83 Bulletin 83/23

(84) Etats contractants désignés:
DE GB NL

(56) Documents cités:
US - A - 4 120 035

IEEE JOURNAL OF SOLID STATE CIRCUITS,
vol. SC-12, no. 6, decembre 1977, New York,
US, Y. A. HAQUE et al.: "Design and
characterization of a real-time correlator, P,
642—649.

(73) Titulaire: THOMSON-CSF
173, Boulevard Haussmann
F-75379 Paris Cedex 08 (FR)

(72) Inventeur: Berger, Jean-Luc
"THOMSON-CSF" - SCPI 173; bld Haussmann
F-75360 Paris Cedex 08 (FR)

(74) Mandataire: Benoit, Monique et al,
THOMSON-CSF SCPI 173, Bld Haussmann
F-75379 Paris Cedex 08 (FR)

Courier Press, Leamington Spa, England.

## Filtre à transfert de charges électriques, programmable numériquement

La présente invention concerne les filtres pour signaux électriques dits filtres transversaux, utilisant le transfert de charges dans un semiconducteur. Elle a plus particulièrement pour objet un filtre qui est programmable par une information numérique.

On rappelle qu'un filtre transversal à transfert de charges est constitué par un substrat semiconducteur, recouvert d'un isolant sur lequel sont disposées des électrodes: ces dernières assurent, par application périodique de potentiels donnés, le transfert de paquets de charges électriques qui représentent le signal à traiter. Ces électrodes sont disposées parallèlement les unes aux autres et transversalement par rapport à la direction de transfert des charges. Certaines de ces électrodes sont divisées transversalement en deux parties inégales et les quantités de charges qui arrivent sous ces électrodes sont lues différentiellement, c'est-à-dire que, par exemple, la partie supérieure de ces électrodes divisées est affectée du signe plus et la partie inférieure du signe moins: on réalise ainsi une pondération du signal par des coefficients égaux respectivement au rapport des longueurs des deux parties des électrodes divisées. Ce signal différentiel constitue le signal de sortie du filtre.

Les avantages de ce type de filtre tiennent principalement aux caractéristiques des dispositifs à transfert de charges, c'est-à-dire simplicité de réalisation et faible consommation.

Un inconvénient important en est que les coefficients de filtrage se trouvent fixés définitivement lors de la fabrication du filtre.

Il est connu par l'article intitulé "Design and Characterization of a Real-Time Correlator" de HAQUE et COPELAND (IEEE Journal of Solid-State Circuits, volume SC-12, N° 6, December 1977, pages 642—649) de réaliser un filtre selon le préambule de la revendication 1 utilisant la technique du transfert de charges, dans lequel la valeur des coefficients de filtrage n'est pas prédéfinie, mais fournie par une information numérique extérieure. Un tel filtre présente l'avantage de s'appliquer indifféremment à de nombreux domaines du traitement du signal, parmi lesquels on peut citer le test rapide de nouveaux procédés de filtrage, la conversion numérique-analogique, les radars, etc. Toutefois cette structure présente l'inconvénient de fournir un signal présentant un niveau de bruit élevé, du fait de la fréquence élevée de la commutation réalisée sur les coefficients.

La présente invention a pour objet un filtre programmable utilisant la technique du transfert de charges, ne présentant pas cet inconvénient.

A cet effet, l'invention comporte au moins p étages distincts, chacun de ces étages comportant au moins: des moyens de réception du signal d'entrée du filtre; un registre à décalage dit registre à coefficients, comportant M étages de transfert dits cellules, ce registre recevant les M bits de même poids des M coefficients, et des moyens de multiplication et de sommation, assurant la multiplication numérique-analogique des informations du signal d'entrée contenues dans les moyens de réception et des informations venant du registre à coefficients, et la sommation de ces résultats, fournissant ainsi le signal de sortie du filtre, ce filtre étant caractérisé par le fait que pour chaque étage, les moyens de réception du signal d'entrée sont un registre à transfert de charges, dit registre signal, comportant au moins M étages de transfert dits cellules dans lesquels le signal d'entrée se propage; que, dans chaque étage, à chacune des M cellules du registre à coefficients est associé un élément de mémoire, connecté à la sortie parallèle de la cellule respective et apte à stocker et disposer au niveau individuel la valeur du bit coefficient en face d'une cellule associée du registre signal pendant toute la durée de fonctionnement du filtre tant que la valeur des coefficients n'est pas modifiée, et que les moyens de multiplication et de sommation assurent, simultanément au niveau de chaque étage, des multiplications en parallèle, des informations contenues respectivement dans un des M éléments de mémoire et la cellule associée du registre signal.

la figure 3a représente un élément de mémoire à transfert de charges utilisé dans le filtre selon l'invention, et la figure 3b est le schéma d'une partie de la figure 3a;

la figure 4 représente des diagrammes (a à e) de signaux se rapportant à la figure 3a;

la figure 5 représente schématiquement une partie d'un des registres numériques utilisés dans le filtre selon l'invention;

la figure 6 représente des diagrammes (a à c) de signaux se rapportant à la figure 5;

la figure 7 représente le détail d'une partie d'un étage du filtre selon l'invention;

la figure 8 représente des diagrammes (a à d) de signaux se rapportant à la figure 7;

la figure 9 représente un exemple de réalisation pratique d'un étage du filtre selon l'invention.

Sur ces différentes figures, les mêmes références se rapportent aux mêmes éléments.

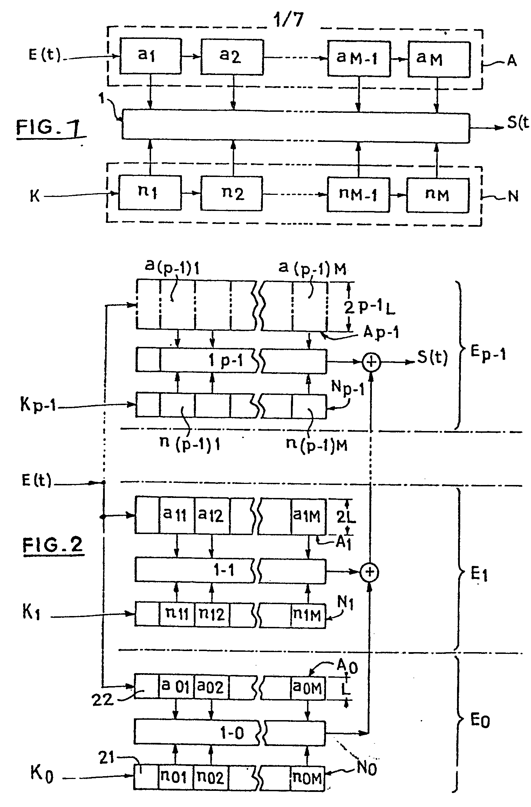

La figure 1 est le schéma général de principe d'un filtre à transfert de charges numériquement programmable. Il est composé principalement de trois éléments:

— un registre à décalage A, dit registre signal, recevant le signal analogique d'entrée E(t) à filtrer;

— un registre à décalage N, dit registre coefficients, recevant sur une entrée K successivement les M coefficients de filtrage exprimés sous forme numérique;

— un opérateur 1 de multiplication numérique-analogique des informations contenues dans les registres A et N, et de sommation des résultats obtenus.

Le registre A comporte une série de M étages de transfert, dits cellules, $a_1...a_M$, introduisant chacun un même retard T. Le registre A est réalisé à l'aide de dispositifs à transfert de charges, la durée T du retard étant donnée par la période des potentiels appliqués aux électrodes assurant le transfert des charges.

Le registre N comporte également M cellules, $n_1...n_M$, destinées à recevoir M coefficients de filtrage; il est également réalisé à l'aide de dispositifs à transfert de charges.

L'opérateur 1 réalise la multiplication du signal E(t) par chacun des M coefficients contenus dans le registre N, et la sommation des résultats obtenus qui constitue le signal filtré S(t), signal de sortie du dispositif.

La figure 2 représente le schéma général du dispositif selon l'invention.

Dans ce dispositif, les coefficients de filtrage sont exprimés sous forme numérique sur p bis, et le schéma de la figure 1 est alors décomposé en p étages, repérés $E_0$, $E_1...E_{p-1}$;

Plus précisément, l'étage $E_0$ se compose de la façon suivante:

— un registre $N_0$ à décalage à transfert de charges, ou registre coefficients, qui reçoit le bit de poids le plus faible ($K_0$) de chacun des M coefficients; il comporte un étage 21 d'injection, recevant le signal $K_0$ et le transformant en paquets de charges, et M cellules $n_{01}...n_{0M}$;

— un second registre à décalage à transfert de charges $A_0$, ou registre signal; il est de largeur L et comporte également un étage d'injection (22), recevant le signal analogique à filtrer E(t) et le transformant en paquets de charges, et M cellules $a_{01}...a_{0M}$;

— un organe 1—0 de multiplication numérique-analogique et de sommation, ou M.N.A.S., réalisant le produit de E(t) par chacun des bits contenus dans le registre $N_0$.

De façon analogue, le second étage ($E_1$) du filtre comporte: un registre coefficient $N_1$, recevant le bit de poids 1 ($K_1$) de chacun des M coefficients; un registre signal $A_1$, de largeur double (2L) de $A_0$, recevant le signal E(t), et un organe M.N.A.S. 1—1 fournissant les produits de E(t) par chacun des bits contenus dans le registre $N_1$.

Les autres étages du filtre sont réalisés de la même façon, jusqu'au dernier étage ($E_{p-1}$) qui comporte: un registre coefficient $N_{p-1}$, recevant le bit ($K_{p-1}$) de poids le plus fort de chacun des M coefficients; un registre signal $A_{p-1}$, de largeur égale à $L(2^{p-1})$, recevant le signal E(t), et un organe MNAS 1-p-1, fournissant les produits E(t) par chacun des bits contenus dans le registre $N_{p-1}$.

On sait que la quantité de charges injectée dans un registre à transfert de charges est fonction de la largeur du registre; les registres signaux $A_0...A_{p-1}$ ayant des largeurs croissant de L à $2^{p-1}L$, les quantités de charges injectées varient en puissance de deux, réalisant ainsi la pondération des bits coefficients. Le signal S(t) de sortie du dispositif est alors obtenu par simple sommation des différents produits élémentaires.

Les différents registres à décalage (A) recevant le signal analogique d'entrée E(t) sont constitués de façon connue, utilisant la technique de transfert de charges C.C.D. (pour Charge Coupled Devices dans la littérature anglo-saxonne) et ne seront pas décrit en détail.

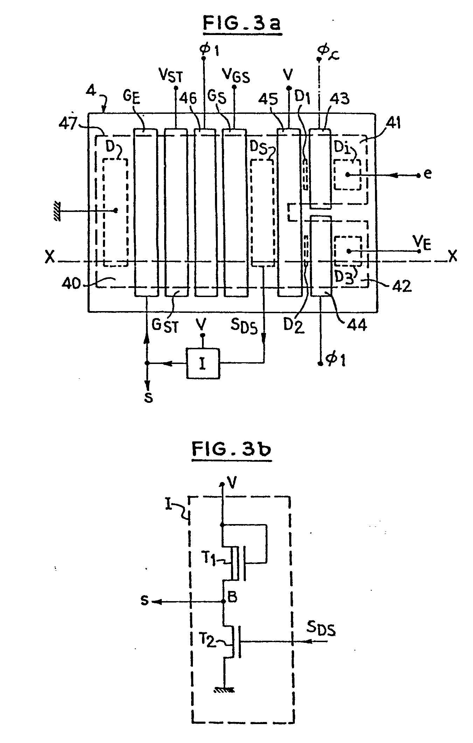

Au contraire, les registres à décalage (N) recevant les coefficients numériques (K) ne sont pas quelconques; ils doivent permettre de disposer les bits des coefficients en face de chaque cellule des registres analogiques (A) et de les maintenir dans cette position pendant toute la durée du fonctionnement du dispositif, tant que la valeur des coefficients de filtrage n'est pas modifiée. A cet effet, on utilise un registre à décalage classique à transfert de charges auquel on adjoint, sur chacune de ses sorties paralleles, un élément de mémoire capable de stocker la valeur du bit coefficient. Il est préférable que ces éléments de mémoire utilisent également la technique du transfert de charges et ils peuvent avantageusement être constitués comme décrit dans la demande de brevet français N° 2.436.468 au nom de THOMSON-CSF, constitution rappelée, dans l'un de ses modes de réalisation, sur la figure 3a de la présente description.

L'élément de mémoire de la figure 3a est vu de dessus. Il est constitué, comme il est classique pour les dispositifs à transfert de charges, par un substrat 4 semiconducteur (silicium par exemple) recouvert d'une couche d'isolant (oxyde de silicium par exemple), et d'électrodes placées sur la couche d'isolant. Cinq de ces électrodes, ou grilles, à savoir successivement $G_E$, $G_{ST}$, 46, $G_S$ et 45, sont disposées parallèlement les unes aux autres, perpendiculairement à la direction XX de transfert des charges dans le semiconducteur, et s'étendent sur toute la largeur du dispositif. A côté de l'électrode 45 sont placées deux demi-électrodes, 43 et 44. Dans le substrat semiconducteur 1, par exemple du type P, sont réalisées des diodes, par exemple par diffusion d'impuretés créant des zones de type N; ces diodes sont placées: la première (D), avant la grille $G_E$ et reliée au potentiel de référence du dispositif (masse); la seconde ($D_S$) entre les électrodes $G_S$ et 45; la troisième ($D_1$), entre les électrodes 45 et 43; la quatrième ($D_i$), après l'électrode 43 et reçoit le signal d'entrée d du dispositif; la cinquième ($D_2$) entre les électrodes 45 et 44, et enfin la sixième ($D_3$), après l'électrode 44. Dans le substrat 1 est réalisée, par tout moyen connu, une barrière d'isolement 47 qui a pour but de définir un canal 40 de transfert des charges entre la diode D et l'électrode 45, et deux demi-canaux parallèles 41 et 42. Ces deux derniers canaux sont issus de la séparation en deux parties du canal 40 sous l'électrode 45, le canal 41 correspondant aux diodes $D_1$, $D_l$ et à l'électrode 43, et le canal 42 aux diodes $D_2$, $D_3$ et à l'électrode 44. Il est à noter que, ainsi qu'il est connu et décrit dans la demande de brevet sus-visée, des moyens (non décrits ici) sont prévus dans ce dispositif pour rendre les transferts de charges unidirectionnels. Le dispositif comporte encore en élément I, inverseur et régénérateur, connecté entre la diode $D_S$ et la grille $G_E$.

Un mode de réalisation de l'élément I est donné figure 3b.

Il est constitué de deux transistors de type MOS, $T_1$ et $T_2$, connectés en série entre un potentiel V et la masse. Il est à noter que le transistor $T_1$ est à déplétion et le transistor $T_2$ à enrichissement. La grille de $T_1$ est reliée au potentiel V alors que la grille de $T_2$ reçoit un signal $S_{DS}$ en provenance de la diode $D_S$. Au point commun B de ces deux transistors est disponible un signal S.

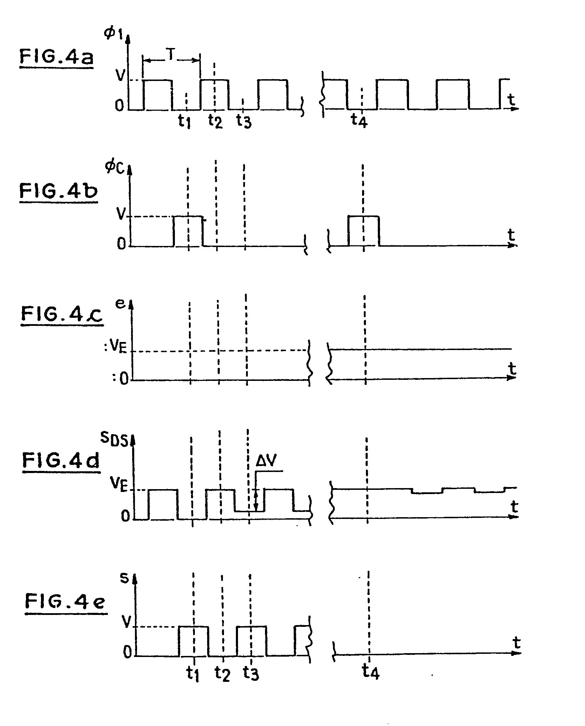

La figure 4 représente, en fonction du temps, des diagrammes (a à e) de signaux applicables au dispositif de la figure 3a, ou fournis par lui.

Le diagramme 4a représente un potentiel $\phi_1$, dit potentiel de transfert, sensiblement en créneaux, de période T et dont l'amplitude varie de préférence entre 0 et V.

Le diagramme 4b représente un potentiel $\phi_C$, dit d'échantillonnage, qui n'est différent de zéro que lorsqu'on désire mémoriser le signal d'entrée e, pendant une durée de T/2, lorsque $\phi_1$ est au niveau bas (zéro), avec une amplitude de préférence égale à V.

Le diagramme 4c représente un exemple de signal d'entrée e appliqué au dispositif.

Le diagramme 4d représente le signal $S_{DS}$ fourni par la diode $D_S$ et alimentant l'inverseur I.

Le diagramme 4e représente le signal s fourni par l'inverseur I, qui d'une part constitue le signal de sortie de l'élément de mémoire et d'autre part est appliqué à la grille $G_E$.

Les potentiels V, $V_{ST}$, $V_{GS}$ et $V_E$ sont des potentiels continus qui sont appliqués respectivement aux grilles 45, $G_{ST}$, et $G_S$, et à la diode $D_3$. A titre d'exemple, le potentiel V peut être égal à 12 volts, $V_E$ est voisin de V mais un peu inférieur, et $V_{ST}$ et $V_{GS}$ sont sensiblement inférieurs, par exemple de l'ordre de 5 volts.

Le fonctionnement de l'élément de mémoire de la figure 3a est le suivant: le bit à mémoriser est appliqué sur l'entrée e et amené sur la diode $D_S$ pendant que le signal $\phi_C$ est en position haute ($\phi_C$=V).

Si le bit d'entrée a la valeur "un", représentée par zéro volt (instant $t_1$ figure 4), le potentiel $S_{DS}$ de la diode $D_S$ prend la valeur zéro volt et le signal de sortie s de l'inverseur I est égal à V volts. Il se produit alors une injection de charges sous les grilles $G_E$ et $G_{ST}$. Ce paquet de charges est ensuite transféré sous l'électrode 46 (instant $t_2$). Pendant ce même temps la diode $D_S$ voit son potentiel $S_{DS}$ restauré à la valeur $V_E$ par le canal 42, ce qui se traduit par s=0 volt. A l'instant suivant ($t_3$), le paquet de charges précédemment sous l'électrode 46 est transféré vers la diode $D_S$ dont il diminue le potentiel d'une valeur $\Delta V$. Si le seuil de l'inverseur I est convenablement choisi par rapport à la valeur de V, le signal s repasse à la valeur zéro volt. On constate donc que, dans le cas où e=zéro volt (bit "un"), le signal de sortie s est un signal en créneaux déphasé de T/2 par rapport à $\phi_1$.

Si le bit d'entrée a la valeur "zéro", représenté par $V_E$ volts, le potentiel $S_{DS}$ de la diode $D_S$ prend la valeur $V_E$ (instant $t_4$) et le signal s la valeur zéro, empêchant toute injection de charges. Aucune charge ne venant réduire le potentiel $S_{DS}$ de la diode $D_S$, celui-ci reste à la valeur $V_E$ et, par suite, le signal de sortie s reste à la valeur zéro.

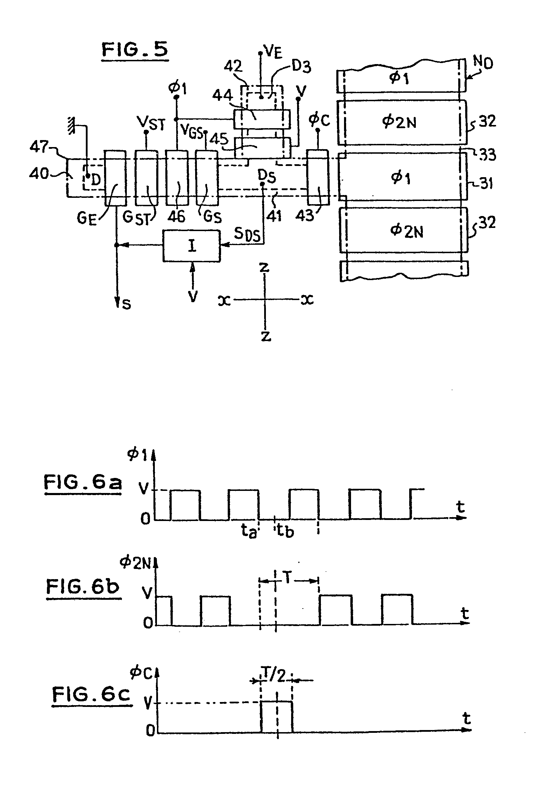

Un élément de mémoire tel que celui qui vient d'être décrit est utilisé à chacune des sorties parallèles des registres à décalage N, comme illustré figure 5.

Sur cette figure, on a représenté par exemple une partie du registre à décalage $N_0$, constitué classiquement par un substrat semiconducteur recouvert d'isolant sur lequel sont déposées des électrodes, identiques et parallèles, auxquelles sont appliqués des potentiels périodiques donnés, par exemple $\phi_1$ pour les électrodes impaires 31 et $\phi_{2N}$ pour les électrodes paires 32; une paire d'électrodes 31—32 définit une cellule (n) du registre $N_0$. Pour simplifier le schéma, le registre $N_0$ n'est représenté que par ses électrodes, à l'intérieur desquelles est noté le potentiel appliqué. Les charges électriques sont transférées d'une électrode à l'autre selon un direction ZZ normale aux électrodes 31 et 32, dans un canal limité par une barrière d'isolement 33.

La barrière d'isolement 33 est interrompue à chaque cellule, c'est-à-dire par exemple au niveau de chaque électrode 31, pour la connexion d'un élément de mémoire. La connexion se fait par le canal 41 qui est dans le prolongement du canal 40, le canal 42 étant disposé perpendiculairement à ceux-ci.

L'élement de mémoire représenté est à titre d'exemple celui décrit dans la figure 3a. Il peut être bien entendu remplacé par l'une quelconque de ses variantes décrites dans la demande de brevet précitée.

L'élément de mémoire est donc identique à celui de la figure 3a, à trois différences près:

— la suppression de la diode $D_l$ du canal 41, qui servait à l'injection du signal d'entrée e, puisque le signal d'entrée est maintenant constitué par un paquet de charges sous l'électrode 31;

— l'orientation du canal 42, qui devient normal à l'axe XX pour des considérations d'encombrement, ce qui modifie légèrement la forme de la diode $D_S$: elle est maintenant en forme de T afin de toujours relier les trois canaux 40, 41 et 42;

— l'électrode 45, reliée au potentiel V, qui ne s'étend plus que sur le canal 42: en effet, sa fonction étant de constituer un écran entre la diode $D_S$ et le potentiel $\phi_1$ appliqué sur l'électrode 44 du canal 42, cette électrode 45 n'est vraiment nécessaire que sur ce dernier canal.

Le fonctionnement de ce dispositif sera expliqué à l'aide de la figure 6, qui représente les signaux $\phi_1$, $\phi_{2N}$ et $\phi_C$ qui lui sont appliqués (respectivement diagrammes 6a, 6b et 6c).

Le signal $\phi_1$ est identique à celui qui est représenté sur le diagramme 4a.

Le signal $\phi_{2N}$ appliqué aux électrodes 32 du registre $N_0$ est de préférence identique au signal $\phi_1$ mais en opposition de phase avec ce dernier, jusqu'à un instant $t_a$.

Avant l'instant $t_a$, les informations numériques sont injectées en série dans le registre $N_0$ et les signaux $\phi_1$ et $\phi_{2N}$ assurent leur transfert jusqu'à ce que ces informations soient disposées sur l'ensemble du registre (à l'instant $t_a$).

Après l'instant $t_a$, qui intervient quand le potentiel $\phi_{2N}$ doit normalement remonter au niveau haut (V), celui-ci reste au niveau bas pendant toute une période (T). A cet instant $t_a$, le signal $\phi_C$ illustré sur le diagramme 6c passe au niveau haut pour une durée voisine de T/2.

A un instant $t_b$ suivant, les potentiels $\phi_1$ et $\phi_{2N}$ sont au niveau bas alors que $\phi_C$ est au niveau haut. Deux cas sont alors possibles:

— si des charges sont présentes sous l'électrode 31 du registre $N_0$, représentant par exemple une information binaire égale à un, ces charges sont toutes transférées par l'action de $\phi_C$ et de $\phi_{2N}$ vers la diode $D_S$, ramenant ainsi le potentiel de $D_S$ vers zéro volt et, par suite, provoquant par l'intermédiaire de l'inverseur I l'injection d'un paquet de charges dans l'élément de mémoire. L'information est ainsi stockée et disponible sur la sortie s sous la forme illustrée sur le diagramme 4 e;

— s'il n'y a pas de paquet de charges sous l'électrode 31 du registre $N_0$, cette absence représentant par exemple une information binaire égale à zéro, la diode $D_S$ reste au niveau $V_E$; le signal s fourni par l'inverseur I est alors nul et il n'y a pas d'injection de paquet de charges dans l'élément mémoire. Le niveau bas est alors conservé par l'élément de mémoire et disponible sur la sortie s.

Le signal s de sortie de l'élément de mémoire est, conformément au schéma de la figure 2, dirigé vers le MNAS de l'étage considéré ($E_0$ dans l'exemple de la figure 5).

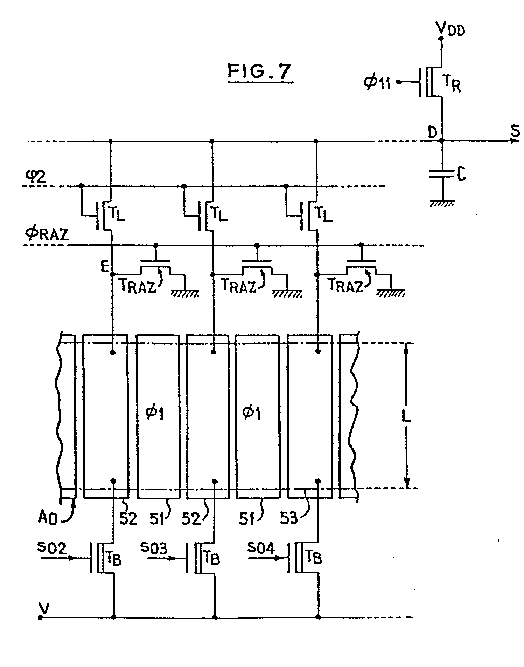

On a représenté figure 7, à titre d'exemple, une partie du registre signal $A_0$, la partie correspondante du MNAS de l'étage $E_0$, ainsi que les arrivées des signaux $S_{02}$, $S_{03}$, $S_{04}$ provenant du registre coefficient correspondant ($N_0$).

Le registre signal $A_0$ est constitué classiquement par un substrat semiconducteur recouvert d'isolant sur lequel sont déposées des électrodes, identiques et parallèles, auxquelles sont appliqués des potentiels périodiques donnés.

Ainsi qu'il est connu et à fin notamment de rendre le transfert des charges unidirectionnel, le registre comporte une première série d'électrodes, 51 et 52 sur la figure, placées sur une épaisseur d'isolant définie, et une seconde dérie d'électrodes, non représentées sur la figure pour plus de clarté, placées sur une surépaisseur d'isolant, entre les électrodes 51 et 52; les électrodes impaires (51) et les électrodes de la seconde série qui les précèdent immédiatement sont portées de préférence au potentiel $\phi_1$; les électrodes de la seconde série qui précèdent immédiatement les électrodes paires (52) sont portées à un potentiel $\phi_2$; une paire d'électrodes 51—52 définit une cellule (a) du registre $A_0$. Pour simplifier le schéma, comme précédemment, le registre $A_0$ n'est représenté que par sa première série d'électrodes, à l'intérieur desquelles est noté le potentiel appliqué. Selon un mécanisme classique, les charges électriques sont transférées d'une électrode à l'autre selon une direction normale aux électrodes 51 et 52, dans un canal de largeur L, limité par une barrière d'isolement 53.

L'organe MNAS correspondant comporte trois séries de M transistors ($T_B$, $T_L$ et $T_{RAZ}$), soit trois transistors par cellule des registres $A_0$ et $N_0$, reliés à un transistor ($T_R$), du type MOS à déplétion, et une capacité (C) communs à tous les étages ($E_0$—$E_{p-1}$). Chacun des M transistors $T_B$, du type MOS à déplétion, est respectivement connecté entre le potentiel V et l'une des électrodes 52 du registre $A_0$, chacune des grilles de ces MOS $T_B$ recevant respectivement les signaux $s_0$ en provenance du registre coefficient $N_0$. Chacune des électrodes 52 est par ailleurs connectée à un point E commun à un des transistors $T_{RAZ}$, du type MOS à enrichissement, et un des transistors $T_L$, également du type MOS à enrichissement; la grille des transistors $T_{RAZ}$ est relié à un potentiel $\phi_{RAZ}$ et la grille des transistors $T_L$ à un potentiel $\varphi_2$; l'autre borne (source) des MOS $T_{RAZ}$ est reliée à la masse, et l'autre borne (drain) des MOS $T_L$ à un point D, commun à tous les étages du filtre. La capacité C est connectée entre D et la masse. Le transistor $T_R$, du type MOS à déplétion, est connecté entre D et un motentiel $V_{DD}$ supérieur à V, la grille de ce transistor étant commandée par un potentiel $\phi_{11}$, en phase avec $\phi_1$ et de même force, mais dont l'amplitude $V_1$ est supérieure à celle de $\phi_1$. En pratique, si le potentiel V est voisin de 12 volts, ce potentiel $V_{DD}$ peut être de l'ordre de 20 volts.

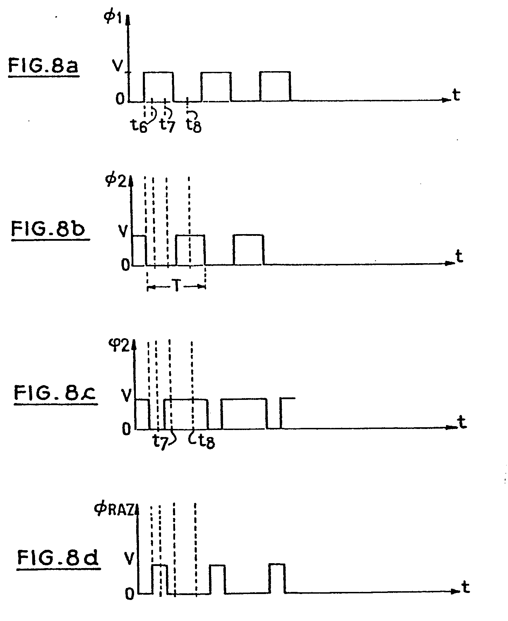

La figure 8 représente les signaux $\phi_1$ $\phi_2$, $\phi_{RAZ}$ et $\varphi_2$ qui sont appliqués au dispositif de la figure 7.

Le signal $\phi_1$ représenté sur le diagramme 8a est identique à celui du diagramme 4a.

Le signal $\phi_2$ est de préférence identique à $\phi_1$, mais en opposition de phase avec ce dernier. Il est représenté sur le diagramme 8b.

Le signal $\varphi_2$ représenté sur le diagramme 8c est de même période T que les précédents, mais la durée de la valeur haute (par exemple également égale à V) est sensiblement supérieure à T/2. Par ailleurs, le front descendant de $\varphi_2$ est en phase avec le front descendant de $\phi_2$.

Le signal $\phi_{RAZ}$ représenté sur la diagramme 8d est le complément du signal $\varphi_2$.

Le fonctionnement de l'étage $E_0$ décrit figure 7 est le suivant:

Lorsqu'un signal $s_o$ est égal à zéro, le transistor $T_B$ correspondant est bloqué et l'ensemble des transistors $T_L$ et $T_{RAZ}$ correspondants, $T_R$ et la capacité C fonctionnent comme un dispositif de lecture en courant d'une quantité de charges, dispositif par exemple décrit dans la demande de brevet N° 2.389.899 au nom de THOMSON-CSF, plus particulièrement figures 4 et 5 de cette demande et dont on rappelle brièvement le fonctionnement ci-dessous:

— pendant le temps $t_6$, $\phi_{11} = V_1$ et $\phi_{RAZ} = V$, donc les transistors $T_R$ et $T_{RAZ}$ sont conducteurs, alors que $\varphi_2 = 0$, bloquant le transistor $T_L$. Le point D est donc porté à un potentiel pratiquement égal à $V_{DD}$, le transistor $T_R$ étant polarisé en triode, et la capacité C se charge.

— pendant le temps $t_7$, $\phi_{11}$ est toujours égal à $V_1$ mais $\phi_{RAZ}$ et $\varphi_2$ sont nuls. Les transistors $T_L$ et $T_R$ sont conducteurs simultanément portant le potentiel de l'électrode 52 considérée à la valeur $(V - V_T)$, l'amplitude V de $\varphi_2$ et le potentiel $V_{DD}$ étant tels que les transistors $T_L$ fonctionnent en saturation, $V_T$ étant la tension de seuil des transistors $T_L$.

— pendant le temps $t_8$, $\phi_{11} = 0$, bloquant le transistor $T_R$ et isolant la capacité C de toute source de tension extérieure. Pendant ce temps $\varphi_2 = V$, et l'arrivée d'un paquet de charges $\Delta Q$ sous l'électrode 52 provoque alors une décharge de la capacité C, entraînant une variation de potentiel

$$\frac{\Delta Q}{C}$$

au point D, qui constitue le signal de sortie du dispositif: en effet, la sommation des contributions de toutes les électrodes 52 des différentes étages se fait automatiquement au point D.

Lorsqu'un signal s reçu sur la grille d'un transistor $T_B$ est différent de zéro, il est au niveau V ainsi qu'il est montré ci-dessus (figure 4), et l'électrode 52 correspondante se trouve portée au potentiel V par l'intermédiaire du transistor $T_B$ correspondant. Cela a pour effet de bloquer le transistor $T_L$ correspondant du fait que le potentiel appliqué à sa source (point E) devient égal à V, valeur du potentiel appliqué sur sa grille (lorsque le potentiel $\varphi_2$ est au niveau haut). La lecture de la quantité de charges sous l'électrode 52 ne peut donc avoir lieu et le point D ne subit pas de variation de potentiel provenant de cet étage.

Le transistor $T_{RAZ}$ a pour fonction la remise à zéro du potentiel du point E après l'opération de lecture, pour évacuer les charges vers l'étage suivant.

Il est à noter que c'est un bit "un" dans le registre coefficient, qui correspond selon la figure 4 à un niveau e=zéro volt, et un signal s différent de zéro qui bloque la lecture du registre signal; il est donc nécessaire de complémenter les bits coefficients avant leur introduction dans les différents registres coefficients N.

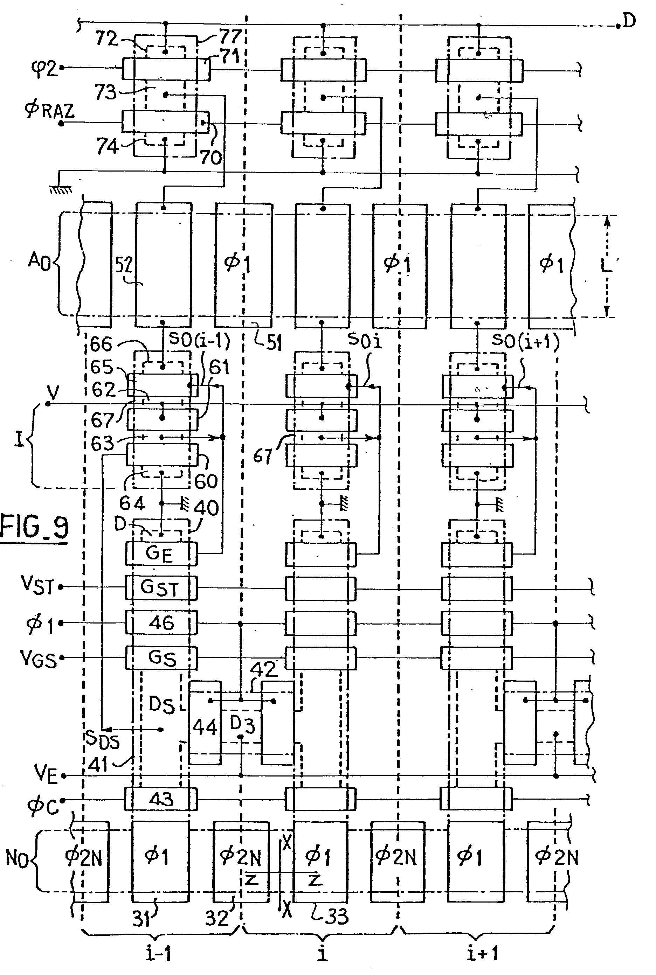

La figure 9 représente un mode de réalisation pratique d'un étage du filtre selon l'invention, par exemple le premier étage $E_0$.

Le registre coefficient est représenté par ses électrodes 31 et 32, respectivement portées au potentiel $\phi_1$ et $\phi_{2N}$. Chaque paire d'électrodes définit une cellule (n) de ce registre; trois de ces cellules sont représentées sur la figure, respectivement $i-1$, $i$ et $i+1$. A chaque électrode 31 est connecté un élément de mémoire de façon analogue à ce qui est décrit sur la figure 5, c'est-à-dire par le canal 41 qui commence par l'électrode 43 reliée au potentiel $\phi_C$. Comme figure 5, le canal 40 est dans le prolongement du canal 41 et le canal 42 est parallèle au registre $N_0$. Toutefois, ce mode de réalisation diffère du précédent sur deux points:

— le canal 42, qui ne comporte pas d'électrode 45 et dont la diode $D_3$ est commune à deux étages adjacents (sur la figure 9, cannaux $i-1$ et $i$);

— l'inverseur I qui est réalisé sur le même substrat que le registre $N_0$ et les éléments de mémoire, dans le prolongement du canal 40.

L'inverseur I comporte trois zones 62, 63 et 64, réalisées dans le substrat et d'un type de conductivité opposé à ce dernier, entre lesquelles sont disposées, sur une couche isolante, deux électrodes parallèles, respectivement 61 et 60, qui constituent les grilles des transistors $T_1$ et $T_2$ de la figure 3b; la zone 64 est reliée à la masse, la zone 63 est la point commun B des deux transistors, sortie (s) de l'inverseur et la zone 62 est portée au potentiel V.

Dans le prolongement des éléments 60 à 64 constituant l'inverseur I est placé le transistor $T_B$ décrit figure 7: il est constitué par la zone 62, une électrode 65 placée après la zone 62 parallèlement aux électrodes 60 et 61, recevant le signal $s_o$ de l'inverseur I, et une zone 66 analogue aux zones 62, 63 et 64, placée après l'électrode 65. Cet ensemble de zones et électrodes 60 à 66 est isolé du reste du substrat par une barrière d'isolement 67.

Le registre signal $A_0$ est représenté par ses électrodes 51 et 52 comme sur la figure 7. Il est réalisé dans le même substrat que les éléments précédents; les électrodes 52 du registre $A_0$ devant recevoir le signal provenant du transistor $T_B$, c'est-à-dire devant être reliées chacune à une zone 66, l'ensemble des électrodes de ce dernier sont placées de telle sorte que les électrodes 52 soient chacune dans le prolongement d'un inverseur I.

Dans le prolongement de chaque électrode 52 sont placés les deux transistors $T_{RAZ}$ et $T_L$ du MNAS correspondant à la cellule considérée. Ils sont constitués par trois zones 72, 73 et 74 réalisées dans le substrat et d'un type de conductivité opposé à ce dernier, entre lesquelles sont disposées, sur une couche isolante, deux électrodes parallèles, respectivement 71 et 70, qui constituent les grilles des transistors $T_L$ et $T_{RAZ}$ de la figure 7. La zone 74 est reliée à la masse; la zone 73 est le point commun E de ces duex transistors et la zone 72 fournit le signal de sortie de la cellule, dirigé vers le point D. L'ensemble des éléments 70 et 74 est isolé du reste du substrat par une barrière d'isolement 77.

Au point D sont connectés le transistor $T_R$, la capacité C et des moyens, classiques, de prélèvement du signal en D, qui peuvent également être intégrés sur le même substrat.

Ce mode de réalisation présente l'avantage d'avoir tous les éléments concernant une même cellule (i) dans le prolongement les uns des autres, ce qui permet d'utiliser des registres à décalage N et A dont le pas, c'est-à-dire la distance entre les milieux de deux électrodes 32 (ou 52) consécutives, est faible. A titre d'exemple il peut être de l'ordre de 40 $\mu$m. A titre d'exemple encore, si on retient pour L une largeur de l'ordre de 40 $\mu$m, on obtient, pour le premier étage $E_0$, une largeur totale, du registre $N_0$ aux zones 72, de l'ordre de 300 à 350 $\mu$m.

Pour obtenir le filtre complet, on dispose autant d'étages tels que celui de la figure 9 qu'il y a de bits (p) pour chacun des coefficients de filtrage, comme illustré figure 2. En ce qui concerne le signe des coefficients, deux solutions sont possibles:

— soit disposer un étage supplémentaire (Ep), analogue aux précédents mais contenant l'information de signe de chacun des M coefficients; cet étage doit alors avoir un poids égal à la somme des poids des étages précédents ($E_0 \ldots E_{p-1}$), c'est-à-dire que la largeur du registre signal ($A_p$) de cet étage doit avoir une largeur égale à $2^p L$; cet étage est connecté à une capacité (C') de même valeur mais distincte de la capacité C commune aux étages précédents; le signal de sortie du filtre est obtenu en faisant la différence, à l'aide par exemple d'un amplificateur différentiel, entre le signal fourni par l'étage de signe ($E_p$) et le signal fourni par l'ensemble des étages précédents ($E_0 \ldots E_{p-1}$);

— soit disposer deux registres coefficients dans chaque étage, un pour chaque signe; cela permet d'éviter l'étage de signe ($E_p$) de la solution précédente, qui présente un inconvénient sur le plan de l'encombrement: le registre signal de cet étage est en effet de largeur égale à L que multiplie un facteur $2^p$.

Par ailleurs, différentes variantes du filtre selon l'invention sont possibles, variantes qui entrent dans le cadre de l'invention et parmi lesquelles on peut citer celle portant sur la réalisation de la pondération des signaux obtenus au niveau de chaque étage ($E_0 \ldots E_{p-1}$). En effet, dans la description ci-dessus, la pondération est réalisée par la largeur des registres signal ($A_0 \ldots A_{p-1}$), et les étages $E_0 - E_{p-1}$ sont reliés à une capacité commune C. Dans une variante non représentée, la pondération peut être réalisée par la variation de valeur de la capacité: tous les registres signal ($A_0 \ldots A_{p-1}$) ont alors même largeur L, mais chacun des étages est relié à une capacité distincte ($C_0 \ldots C_{p-1}$) dont les valeurs sont les suivantes:

— pour l'étage $E_0$: $C_0$

— pour l'étage $E_1$: $C_1 = \dfrac{C_0}{2}$

— pour l'étage $E_2$: $C_2 = \dfrac{C_0}{4}$

— pour l'étage $E_{p-1}$: $C_{p-1} = \dfrac{C_0}{2^{p-1}}$

Les signaux fournis par les différents étages sont alors sommés classiquement, par exemple à l'aide d'un amplificateur opérationnel. Dans ce cas, le signe peut être traité comme précédemment. En particulier il peut être porté par un étage supplémentaire $E_p$, relié à une capacité distincte

$$C_p = \frac{C_0}{2^p}.$$

## Revendications

1. Filtre à transfert de charges électriques, programmable numériquement, recevant un signal analogique (E) à filtrer et M coefficients de filtrage (K) exprimés numériquement chacun sur p bits, comportant au moins p étages distincts, chacun de ces étages comportant au moins: des moyens de réception (A) du signal (E) d'entrée du filtre; un registre à décalage dit registre à coefficients (N), comportant M étages de transfert dits cellules, ce registre recevant les M bits de même poids des M coefficients, et des moyens ($T_B$, $T_{RAZ}$, $T_L$, C, $T_R$) de multiplication et de sommation, assurant la multiplication numérique-analogique des informations du signal (E) d'entrée contenues dans les moyens (A) de réception et des informations venant du registre à coefficients (N), et la sommation de ces résultats, fournissant ainsi le signal de sortie (S) du filtre, ce filtre étant caractérisé par le fait que pour chaque étage, les moyens (A) de réception du signal (E) d'entrée sont un registre à transfert de charges, dit registre signal, comportant au moins M étages de transfert dits cellules dans lesquels le signal (E) d'entrée se propage; que, dans chaque étage, à chacune des M cellules du registre à coefficients (N) est associé un élément de mémoire, connecté à la sortie parallèle de la cellule respective et apte à stocker et disposer au niveau individuel la valeur du bit coefficient en face d'une cellule associée du registre signal (A) pendant toute la durée de fonctionnement du filtre tant que la valeur des coefficients n'est pas modifiée, et que les moyens ($T_B$, $T_{RAZ}$, $T_L$, C, $T_R$) de multiplication et de sommation assurent, simultanément au niveau de chaque étage, des multiplications en parallèle, des informations contenues respectivement dans un des M éléments de mémoire et la cellule associée du registre signal.

2. Filtre selon la revendication 1, caractérisé par le fait que chacun des registres à coefficients (N) comporte un substrat semi-conducteur dans lequel des charges électriques sont susceptibles d'être transférées à l'aide d'électrodes disposées sur le substrat, sur commande de potentiels périodiques appliqués à ces électrodes, ces dernières définissant les M cellules.

3. Filtre selon la revendication 1, caractérisé par le fait que chacun des éléments de mémoire comporte:

— une diode, dite diode de sortie ($D_S$);
— un premier canal (41) de transfert des charges, relié à une cellule du registre a coefficients (N) et recevant le signal à mémoriser, comportant une eléctrode (43) à laquelle est appliqué un potentiel d'échantillonnage ($\phi_c$), assurant l'échantillonnage et l'application du signal à mémoriser à la diode de sortie ($D_S$);
— des moyens (I) d'inversion et de régénération du signal ($S_{DS}$) fourni par la diode de sortie ($D_S$), ces derniers moyens fournissant le signal de sortie (s) de l'élément de mémoire;
— des moyens d'injection dans le substrat de paquets de charges représentant ce signal de sortie (s);
— un deuxième canal (40) de transfert de charges, portant des électrodes auxquelles sont appliqués des potentiels périodiques, dits potentiels de transfert, tels que les paquets de charges se propagent dans le deuxième canal (40) et rejoignent la diode de sortie ($D_S$) avec un retard défini par rapport à leur instant d'injection;
— un troisième canal (42) de transfert de charges, comportant une diode ($D_3$) à laquelle est appliqué un premier potentiel constant ($V_E$) et une électrode (44) à laquelle est appliqué un potentiel périodique de transfert ($\phi_1$) tel que ce potentiel constant ($V_E$) soit appliqué à la diode de sortie ($D_S$) lorsque le signal à mémoriser ne l'est pas.

4. Filtre selon la revendication 3, caractérisé par le fait que lesdits moyens d'injection comportent une diode (D) et deux électrodes ($G_E$ et $G_{ST}$), la diode (D) étant maintenue au potentiel de référence du dispositif, la première électrode ($G_E$) recevant le signal de sortie (s) de l'élément de mémoire et la seconde électrode ($G_{ST}$) étant portée à un deuxième potentiel constant ($V_{ST}$).

5. Filtre selon l'une des revendications 3 ou 4, caractérisé par le fait que les moyens (I) d'inversion et de régénération comportent deux transistors ($T_1$, $T_2$) du type MOS reliés en série entre la masse et un troisième potentiel constant (V), leur point commun (B) fournissant le signal de sortie (s) de l'élément de mémoire, la grille du transistor ($T_2$) relié au potentiel de référence du dispositif, recevant le signal de sortie ($S_{DS}$) de la diode de sortie ($D_S$), et la grille du second transistor ($T_1$) étant reliée au troisième potentiel constant (V).

6. Filtre selon l'une des revendications 3 à 5, caractérisé par le fait que le deuxième canal (40) comporte, après les moyens d'injection, une électrode (46) reliée à un potentiel de transfert ($\phi_1$).

7. Filtre selon l'une des revendications précédentes, caractérisé par le fait que chacun des registres signal ($A_0$...$A_{p-1}$) comporte un substrat semiconducteur dans lequel des charges électriques sont susceptibles d'être transférées à l'aide d'électrodes déposées sur le substrat, sur commande de potentiels périodiques appliqués à ces électrodes, ces dernières définissant M étages de transfert dits cellules, la largeur de chacun de ces registres (A) étant sensiblement de la forme $2^kL$, où $0 \leqslant k < p$, L étant une largeur donnée et k étant le poids des bits des coefficients contenus dans le registre coefficients correspondants.

8. Filtre selon les revendications 2 et 7, caractérisé par le fait que les moyens de multiplication et de sommation comportent:

— un ensemble connecté en un point D commun aux p étages du filtre, comportant une capacité (C) connectée entre ce point commun D et le potentiel de référence du dispositif, et un transistor ($T_R$) connecté entre le point commun D et une source extérieure de potentiel continu ($V_{DD}$), commandé en phase avec un premier potentiel périodique de transfert $(\phi_1)$;

— au niveau de chaque étage, trois séries de M transistors ($T_B$, $T_L$ et $T_{RAZ}$), réalisant, sur commande des signaux de sortie (s) des M éléments de mémoire du registre a coefficients (N) et en combinaison avec l'ensemble précédent, la lecture des quantités de charges présentes respectivement sous les M électrodes (52) du registre signal (A) qui sont précédées d'électrodes de transfert commandées par un second potentiel périodique de transfert $(\phi_2)$ en opposition de phase avec le premier potentiel de transfert $(\phi_1)$, cette lecture fournissant le signal de sortie du filtre.

9. Filtre selon la revendication 8, caractérisé par le fait que, pour chaque étage, chacun des transistors ($T_B$) de la première série est connecté entre un troisième potentiel constant (V) et une électrode (52) du registre signal (A) qui est précédée d'une électrode de transfert commandée par le second potentiel de transfert $(\phi_2)$, et qu'il reçoit sur sa grille un signal de sortie (s) d'un élément de mémoire.

10. Filtre selon la revendication 8, caractérisé par le fait que pour chaque étage, chacun des transistors ($T_L$) de la deuxième série a un point commun E avec un transistor ($T_{RAZ}$) de la troisième série, ce dernier ($T_{RAZ}$) étant connecté entre le point E et le potentiel de référence du dispositif, et recevant sur sa grille un potentiel périodique $(\phi_{RAZ})$ tel qu'il assure la remise à zéro au point E, les transistors ($T_L$) de la deuxième série étant chacun connectés entre le point E et le point D et recevant sur sa grille un potentiel périodique $(\varphi_2)$ complément du précédent $(\phi_{RAZ})$, de sorte qu'il fonctionne en saturation.

11. Filtre selon les revendications 3 et 8, caractérisé par le fait que, pour chaque étage, les premier (41) et deuxième (40) canaux de chacun des éléments de mémoire sont placés normalement à la direction (ZZ) de transfert des charges dans le registre à coefficients (N) correspondant; que le troisième canal (42) est placé parallèlement à cette même direction, les éléments de mémoire adjacents, pris deux par deux, ayant en commun la diode ($D_3$) du troisième canal; que les moyens (I) d'inversion et de régénération sont réalisés sur le même substrat que le registre coefficients (N) et placés dans le prolongement du deuxième canal; que le transistor ($T_B$) correspondant de la première série est placé dans le prolongement des moyens (I) d'inversion; que le registre signal (A) est réalisé sur le même substrat que le registre à coefficients (N) et placé à proximité des transistors ($T_B$) de la première série de sorte que la direction (ZZ) de transfert des charges dans le registre signal (A) soit la même que dans le registre coefficients, et que les transistors correspondants des deuxième et troisième séries ($T_L$ et $T_{RAZ}$) sont réalisés sur le même substrat et placés dans le prolongement des moyens d'inversion (I), à proximité du registre signal (A).

12. Filtre selon les revendications 4 et 8, caractérisé par le fait qu'il comporte un étage supplémentaire ($E_p$) représentant le signe des M coefficients, comportant un registre signal de largeur $2^pL$ et un registre coefficients, les moyens de multiplication et de sommation comportant en outre une seconde capacité (C'), de même valeur que ladite capacité (C), connectée au point de sortie de cet étage supplémentaire et trois séries de M transistors ($T_B$, $T_L$, $T_{RAZ}$), le signal de sortie du filtre étant constitué par la différence entre le signal fourni pas cet étage supplémentaire ($E_p$) et le signal fourni par les p autres étages ($E_0...E_{p-1}$).

13. Filtre selon l'une des revendications 1 à 6 caractérisé par le fait que chacun des registres signal ($A_0...A_{p-1}$) comporte un substrat semi-conducteur dans lequel des charges électriques sont susceptibles d'être transférées à l'aide d'électrodes déposées sur le substrat, sur commande de potentiels périodiques appliqués à ces électrodes ces dernières définissant M étages de transfert dits cellules, la largeur de ces registres étant la même pour tous les étages ($E_0...E_{p-1}$).

14. Filtre selon les revendications 2 et 13, caractérisé par le fait que les moyens de multiplication et de sommation comportent, au niveau de chaque étage:

— une capacité ($C_0...C_{p-1}$) dont la valeur est distincte pour chaque étage et de la forme

$$\frac{C_0}{2^k},$$

avec $0 \leqslant k < p$, k étant le poids des bits des coefficients contenus dans le registre coefficients (N) correspondant;

— trois séries de M transistors ($T_B$, $T_L$, et $T_{RAZ}$), réalisant, sur commande des signaux de sortie (s) des M éléments de mémoire du registre à coefficients (N), et en combinaison avec la capacité précédente, la lecture des quantités de charges présentes respectivement sous les M électrodes (52) du registre signal (A) qui sont précédées d'électrodes de transfert commandées par un second potentiel périodique de transfert $(\phi_2)$ en opposition de phase avec le premier potentiel de transfert $(\phi_1)$, les signaux disponibles aux bornes des p capacités ($C_0...C_{p-1}$) étant sommés pour fournir le signal de sortie du filtre.

15. Filtre selon la revendication 14, caractérisé par le fait qu'il comporte un étage supplémentaire ($E_p$) représentant le signe des M coefficients, comportant un registre signal de même largeur que les p autres registres signal ($A_0...A_{p-1}$), et un registre à coefficients, les moyens de multiplication et de sommation comportant en outre, au niveau de l'étage supplémentaire $(E_p)$, une capacité $(C_p)$ de valeur

$$\frac{C_0}{2^p}$$

et trois séries de M transistors $(T_B, T_L$ et $T_{RAZ})$, le signal de sortie du filtre étant constitué par la différence entre le signal fourni par cet étage supplémentaire $(E_p)$ et le signal fourni par les p autres étages $(E_0 \ldots E_{p-1})$.

## Patentansprüche

1. Digital programmierbares, mit Verschiebung elektrischer Ladungen arbeitendes Filter, das ein zu filterndes Analogsignal (E) und M Filterkoeffizienten (K) empfängt, die jeweils digital durch p Bits ausgedrückt werden, mit wenigstens p verschiedenen Stufen, wobei jede dieser Stufen wenigstens enthält: Empfangsmittel (A) zum Empfangen des Eingangssignals (E) des Filters; ein als Koeffizientenregister (N) bezeichnetes Schieberegister, das M als Zellen bezeichnete Verschiebestufen umfaßt, wobei dieses Register die M Bits derselben Wertigkeit der M Koeffizienten empfängt; und Multiplikations- und Summiermittel $(T_B, T_{RAZ}, T_L, C, T_R)$, welche die Digital-Analog-Multiplikation der Informationen des Eingangssignals (E), die in den Empfangsmitteln (A) enthalten sind, mit den aus dem Koeffizientenregister (N) kommenden Informationen sowie die Summierung dieser Ergebnisse gewährleisten und so das Ausgangssignal (S) des Filters liefern; wobei dieses Filter dadurch gekennzeichnet ist, daß für jede Stufe die Empfangsmittel (A) zum Empfangen des Eingangssignals (E) aus einem als Signalregister bezeichneten Ladungsverschieberegister gebildet sind, das wenigstens M als Zellen bezeichnete Verschiebestufen enthält, in denen das Eingangssignal (E) fortschreitet; daß in jeder Stufe jeder der M Zellen des Koeffizientenregisters (N) ein Speicherelement zugeordnet ist, das mit dem parallelen Ausgang der entsprechenden Zelle verbunden und geeignet ist, während der gesamten Funktionsdauer des Filters solange, wie der Wert der Koeffizienten nicht verändert wird, den Wert des Koeffizientenbits zu speichern und auf dem individuellen Niveau gegenüber einer zugeordneten Zelle des Signalregisters (A) anzulegen, und daß die Multiplikations- und Summiermittel $(T_B, T_{RAZ}, T_L, C, T_R)$ auf dem Niveau jeder Stufe gleichzeitig parallele Multiplikationen der Informationen durchführen, von denen die einen in einem der M Speicherelemente und die anderen in der zugeordneten Zelle des Signalregisters enthalten sind.

2. Filter nach Anspruch 1, dadurch gekennzeichnet, daß jedes der Koeffizientenregister (N) ein Halbleitersubstrat umfaßt, in dem die elektrischen Ladungen mittels auf dem Substrat angeordneter Elektroden verschoben werden sollen unter Steuerung von periodischen Potentialen, die an diese Elektroden angelegt sind, wobei diese Elektroden die M Zellen definieren.

3. Filter nach Anspruch 1, dadurch gekennzeichnet, daß jedes Speicherelement umfaßt:

— eine als Ausgangsdiode bezeichnete Diode $(D_S)$:
— einen ersten Ladungsverschiebekanal (41), der an eine Zelle des Koeffizientenregisters (N) angeschlossen ist und das zu speichernde Signal empfängt, mit einer Elektrode (43), an die ein Tastpotential $(\phi_C)$ angelegt ist, welches die Tastung und das Anlegen des zu speichernden Signals an die Ausgangsdiode $(D_S)$ gewährleistet;
— Mittel (I) zum Invertieren und Regenerieren des Signals $(S_{DS})$, das von der Ausgangsdiode $(D_S)$ abgegeben wird, wobei diese Mittel das Ausgangssignal (s) des Speicherelementes liefern;
— Injektionsmittel zum Injizieren von dieses Ausgangssignal (s) darstellenden Ladungspaketen in das Substrat;
— einen zweiten Ladungsverschiebekanal (40), der Elektroden trägt, an die periodische Potentiale bzw. Verschiebepotentiale angelegt sind, dergestalt, daß die Ladungspakete in dem zweiten Kanal (40) fortschreiten und die Ausgangsdiode $(D_S)$ mit einer Verzögerung erreichen, die in bezug auf ihrem Injektionszeitpunkt definiert ist;
— einen dritten Ladungsverschiebekanal (42), der eine Diode $(D_3)$ aufweist, an die ein erstes konstantes Potential $(V_E)$ angelegt ist, und eine Elektrode (44) aufweist, an die ein periodisches Verschiebepotential $(\phi_1)$ angelegt ist, dergestalt, daß dieses konstante Potential $(V_E)$ an die Ausgangsdiode $(D_S)$ angelegt wird, wenn das zu speichernde Signal nicht daran angelegt wird.

4. Filter nach Anspruch 3, dadurch gekennzeichnet, daß die Injektionsmittel eine Diode (D) und zwei Elektroden $(G_E, G_{ST})$ aufweisen, wobei die Diode (D) auf dem Bezugspotential der Vorrichtung gehalten ist, die erste Elektrode $(G_E)$ das Ausgangssignal (s) des Speicherelementes empfängt und die zweite Elektrode $(G_{ST})$ auf ein zweites konstantes Potential $(V_{ST})$ gelegt ist.

5. Filter nach Anspruch 3 oder 4, dadurch gekennzeichnet, daß die Mittel (I) zum Invertieren und Regenerieren zwei MOS-Transistoren $(T_1, T_2)$ umfassen, die in Reihe zwischen Masse und ein drittes konstantes Potential (V) geschaltet sind, wobei der gemeinsame Verbindungspunkt (B) das Ausgangssignal (s) des Speicherelementes liefert, das mit dem Bezugspotential der Vorrichtung verbundenen Transistors $(T_2)$ das Ausgangssignal $(S_{DS})$ der Ausgangsdiode $(D_S)$ empfängt und wobei das Gate des zweiten Transistors $(T_1)$ an das dritte konstante Potential (V) angelegt ist.

6. Filter nach einem der Ansprüche 3 bis 5, dadurch gekennzeichnet, daß der zweite Kanal (40) hinter den Injektionsmitteln eine Elektrode (46) aufweist, die auf ein Verschiebepotential $(\phi_1)$ gelegt ist.

7. Filter nach einem der vorstehenden Ansprüche, dadurch gekennzeichnet, daß jedes Signalregister $(A_0...A_{p-1})$ ein Halbleitersubstrat aufweist, in dem die elektrischen Ladungen mittels auf dem Substrat angeordneten Elektroden verschiebbar sind unter Steuerung von periodischen Potentialen, die an diese Elektroden angelegt sind, wobei diese Elektroden M als Zellen bezeichnete Verschiebestufen bilden und wobei die Breite jedes dieser Register (A) im wesentlichen dem Ausdruck $2^k L$ gehorcht, worin $0 \leqslant k < p$, während L eine gegebene Breite und k der Stellenwert der in den entsprechenden Koeffizientenregistern enthaltenen Koeffizientenbits ist.

8. Filter nach den Ansprüchen 2 und 7, dadurch gekennzeichnet, daß die Multiplikations- und Summiermittel umfassen:

— eine an einen den p Filterstufen gemeinsamen Punkt D angeschlossene Gruppe, die eine zwischen diesen gemeinsamen Punkt D und das Bezugspotential der Vorrichtung geschaltete Kapazität (C) une einen Transistor $(T_R)$ enthält, der zwischen den gemeinsamen Punkt D und eine äußere Gleichspannungsquelle $(V_{DD})$ geschaltet ist und gleichphasig mit einem ersten periodischen Verschiebepotential $(\phi_1)$ gesteuert wird;
— auf dem Niveau jeder Stufe drei Reihen von M Transistoren $(T_B, T_L$ und $T_{RAZ})$, die unter Steuerung der Ausgangssignale (s) der M Speicherelemente des Koeffizientenregisters (N) und in Kombination mit der vorgenannten Gruppe das Auslesen der Ladungsmengen durchführt, die jeweils unter den M Elektroden (52) des Signalregisters (A) vorhanden sind, welchen Verschiebeelektroden vorausgehen, die durch ein zweites periodisches Verschiebepotential $(\phi_2)$ gesteuert sind, dessen Phasenlage entgegengesetzt derjenigen des ersten Verschiebepotentials $(\phi_1)$ ist, wobei dieses Auslesen das Ausgangssignal des Filters liefert.

9. Filter nach Anspruch 8, dadurch gekennzeichnet, daß für jede Stufe jeder der Transistoren $(T_B)$ der ersten Reihe zwischen ein drittes konstantes Potential (V) und eine Elektrode (52) des Signalregisters (A) geschaltet ist, der eine Verschiebeelektrode vorausgeht, die durch das zweite Verschiebepotential $(\phi_2)$ gesteuert ist, und daß er an seinem Gate ein Ausgangssignal (s) eines Speicherelementes empfängt.

10. Filter nach Anspruch 8, dadurch gekennzeichnet, daß in jeder Stufe jeder der Transistoren $(T_L)$ der zweiten Reihe einen gemeinsamen Punkt (E) mit einem Transistor $(T_{RAZ})$ der dritten Reihe aufweist, wobei dieser Transistor $(T_{RAZ})$ zwischen den Punkt E und das Bezugspotential der Vorrichtung geschaltet ist und an seinem Gate ein solches periodisches Signal $(\phi_{RAZ})$ empfängt, daß er die Nullrücksetzung am Punkte E gewährleistet, und wobei die Transistoren $(T_L)$ der zweiten Reihe jeweils zwischen den Punkt E und den Punkt D geschaltet sind und an ihrem Gate jeweils ein periodisches Potential $(\phi_2)$ empfangen, das komplementär zu dem vorgenannten Potential $(\phi_{RAZ})$ ist, so daß sie in Sättigung arbeiten.

11. Filter nach Ansprüchen 3 und 8, dadurch gekennzeichnet, daß für jede Stufe der erste Kanal (41) und der zweite Kanal (40) jedes der Speicherelemente senkrecht zu der Verschieberichtung (ZZ) der Ladungen in dem entsprechenden Koeffizientenregister (N) angeordnet sind; daß der dritte Kanal (42) parallel zu dieser selben Richtung angeordnet ist und die paarweise aneinander angrenzenden Speicherelemente die Diode $(D_3)$ des dritten Kanals gemeinsam haben; daß die Mittel (I) zum Invertieren und Regenerieren auf demselben Substrat wie das Koeffizientenregister (N) verwirklicht und in der Verlängerung des zweiten Kanals angeordnet sind; daß der entsprechende Transistor $(T_B)$ der ersten Reihe in der Verlängerung der Invertiermittel (I) angeordnet ist; daß das Signalregister (A) auf demselben Substrat wie das Koeffizientenregister (N) verwirklicht und in der Nähe der Transistoren $(T_B)$ der ersten Reihe derart angeordnet ist, daß die Ladungsverschieberichtung (ZZ) in dem Signalregister (A) dieselbe wie in dem Koeffizientenregister ist; und daß die entsprechenden Transistoren der zweiten und dritten Reihe $(T_L$ und $T_{RAZ})$ auf demselben Substrat verwirklicht und in der Verlängerung der Invertiermittel (I) in der Nähe des Signalregisters (A) angeordnet sind.

12. Filter nach Ansprüchen 4 und 8, dadurch gekennzeichnet, daß es eine zusätzliche Stufe $(E_p)$ enthält, welche das Vorzeichen der M Koeffizienten darstellt, mit einem Signalregister der Breite $2^p L$ und einem Koeffizientenregister, wobei die Multiplikations- und Summiermittel ferner eine zweite Kapazität (C') desselben Wertes wie die erstgenannte Kapazität (C) umfassen, die an den Ausgangspunkt dieser zusätzlichen Stufe angeschlossen ist, und drei Reihen von M Transistoren $(T_B, T_L, T_{RAZ})$ umfassen, und wobei das Ausgangssignal des Filters durch die Differenz zwischen dem von dieser zusätzlichen Stufe $(E_p)$ gelieferten Signal und dem durch die p anderen Stufen $(E_0...E_{p-1})$ gelieferten Signal gebildet ist.

13. Filter nach einem der Ansprüche 1 bis 6, dadurch gekennzeichnet, daß jedes der Signalregister $(A_0...A_{p-1})$ ein Halbleitersubstrat aufweist, in dem elektrische Ladungen mittels auf dem Substrat angeordneter Elektroden verschiebbar sind unter Steuerung von periodischen Potentialen, die an diese Elektroden angelegt werden, wobei diese Elektroden M als Zellen bezeichnete Verschiebestufen definieren und wobei die Breite dieser Register für alle Stufen $(E_0...E_{p-1})$ dieselbe ist.

14. Filter nach den Ansprüchen 2 und 13, dadurch gekennzeichnet, daß die Multiplikations- und Summiermittel auf dem Niveau jeder Stufe umfassen:

— eine Kapazität $(C_0...C_{p-1})$, deren Wert

$$\frac{C_0}{2^k}$$

für jede Stufe verschieden ist, mit $0 \leqslant k < p$, worin k der Stellenwert der Koeffizientenbits ist, die in dem entsprechenden Koeffizientenregister (N) enthalten sind;
— drei Reihen von M Transistoren $(T_B, T_L$ sowie $T_{RAZ})$, die unter Steuerung der Ausgangssignale (s) der M Speicherelemente des Koeffizientenregisters (N) und in Kombination mit der vorgenannten Kapazität das Auslesen der Ladungsmengen durchführen, die jeweils unter den M Elektroden (52) des Signalregisters (A) vorhanden sind, welchen Verschiebeelektroden vorausgehen, die durch ein zweites periodisches Verschiebepotential $(\phi_2)$ gesteuert sind, dessen Phasenlage entgegengesetzt derjenigen des ersten Verschiebepotentials $(\phi_1)$ ist, wobei die an den Anschlüssen der p Kapazitäten $(C_0...C_{p-1})$ verfügbaren Signale summiert werden, um das Ausgangssignal des Filters zu bilden.

15. Filter nach Anspruch 14, dadurch gekennzeichnet, daß es eine zusätzliche Stufe $(E_p)$ enthält, welche das Vorzeichen der M Koeffizienten darstellt, mit einem Signalregister derselben Breite wie die p anderen Signalregister $(A_0...A_{p-1})$ und einem Koeffizientenregister, wobei die Multiplikations- und Summiermittel ferner auf dem Niveau jeder zusätzlichen Stufe $(E_p)$ eine Kapazität $(C_p)$ des Wertes

$$\frac{C_0}{2^p}$$

und drei Reihen von M Transistoren $(T_B, T_L$ sowie $T_{RAZ})$ aufweisen, und wobei das Ausgangssignal des Filters durch die Differenz zwischen dem von dieser zusätzlichen Stufe $(E_p)$ gelieferten Signal und dem von den p anderen Stufe $(E_0...E_{p-1})$ gelieferten Signal gebildet ist.

**Claims**

1. Digitally programmable electric charges transfer filter receiving an analog signal (E) to be filtered and M filtering coefficients (K) which are digitally expressed on p bits, comprising at least p distinct stages, each of these stages comprising at least: reception means (A) for receiving the input signal (E) of the filter; a shift register, termed coefficient register (N), comprising M transfer stages, termed cells, this register receiving the M bits of the same weight of the M coefficients; and multiplication and summing means $(T_B, T_{RAZ}, T_L, C, T_R)$ assuring the digital-analog multiplication of the information of the input signal (E) contained in the reception means (A) and the information from the coefficient register (N), as well as summing of these results, thus providing the output signal (S) of the filter, this filter being characterized by the fact that for each stage the reception means (A) of the input signal (E) are a charge transfer register, termed signal register, comprising at least (M) transfer stages, termed cells, in which the input signal (E) propagates; that in each stage, a memory element is associated with each of the M cells of the coefficient register (N), the memory element being connected to the parallel output of the respective cell and adapted to store and dispose, on the individual level, the value of the coefficient bit in front of an associated cell of the signal register (A) during the entire duration of operation of the filter as long as the value of the coefficients is not modified, and in that the multiplication and summing means $(T_B, T_{RAZ}, T_L, C, T_R)$ provide for the parallel multiplications of the information contained in one of the M memory elements and the associated cell of the signal register, respectively, simultaneously on the level of each stage.

2. Filter in accordance with claim 1, characterized by the fact that each of the coefficient registers (N) comprises a semiconductor substrate in which the electric charges are susceptible of being transferred by means of electrodes located on the substrate, upon control of periodic potentials applied to these electrodes, the latter defining the M cells.

3. Filter in accordance with claim 1, characterized by the fact that each of the memory elements comprises:

— a diode, termed output diode $(D_S)$;
— a first charge transfer channel (41) connected to one cell of the coefficient register (N) and receiving the signal to be stored, comprising an electrode (43) to which a sampling potential $(\phi_C)$ is applied, providing for the sampling and application of the signal to be stored to the output diode $(D_S)$;
— means (I) for inversion and regeneration of the signal $(S_{DS})$ provided by the output diode $(D_S)$, the latter means providing the output signal (s) of the memory element;
— injection means for injecting charge packets representing the output signal (s) into the substrate;
— a second charge transfer channel (40) carrying the electrodes to which such periodic potentials, termed transfer potentials, are applied that the charge packets propagate through the second channel (40) and reach the output diode $(D_S)$ with a delay defined with respect to their injection moment;

— a third charge transfer channel (42) comprising a diode ($D_3$) to which a first constant potential ($V_E$) is applied and an electrode (44) to which such periodic transfer potential ($\phi_1$) is applied that this constant potential ($V_E$) is applied to the output diode ($D_s$) when the signal to be stored is not applied.

4. Filter in accordance with claim 3, characterized by the fact that said injection means comprise a diode (D) and two electrodes ($G_E$ and $G_{ST}$), the diode (D) being held on the reference potential of the device, the first electrode ($G_E$) receiving the output signal (s) of the memory element and the second electrode ($G_{ST}$) being connected to a second constant potential ($V_{ST}$).

5. Filter in accordance with any of claims 3 and 4, characterized by the fact that the invention and regeneration means (I) comprise two transistors ($T_1$, $T_2$) of MOS type connected in series between ground and a third constant potential (V), their common point (B) providing the output signal (s) of the memory element, the gate of the transistor ($T_2$) connected to the reference potential of the device receiving the output signal ($S_{DS}$) of the output diode ($D_s$), and the gate of the second transistor ($T_1$) being connected to the third constant potential (V).

6. Filter in accordance with any of claims 3 to 5, characterized by the fact that the second channel (40) comprises an electrode (46) connected to a transfer potential ($\phi_1$) and following the injection means.

7. Filter in accordance with any of the preceding claims, characterized by the fact that each of the signal registers ($A_0...A_{p-1}$) comprises a semiconductor substrate in which the electric charges are susceptible of being transferred by means of electrodes located on the substrate, under control of periodic potentials applied to these electrodes, the latter defining M transfer stages, termed cells, the width of each of these registers (A) being substantially of the form $2^kL$, wherein $0 \leqslant k < p$, L being a determined width and k being the weight of the bits of the coefficients contained in the corresponding coefficient register.

8. Filter in accordance with claims 2 and 7, characterized by the fact that the multiplication and summing means comprise:

— a unit connected to the p stages of the filter at a common point D, comprising a capacity (C) connected between the common point D and the reference potential of the device, and a transistor ($T_R$) connected between the common point D and an exterior continuous potential source ($V_{DD}$), and controlled in phase with a first periodic transfer potential ($\phi_1$);
— on the level of each stage, three series of M transistors ($T_B$, $T_L$ and $T_{RAZ}$) providing for the reading of the charge quantities respectively present beneath the M electrodes (52) of the signal register (52) which are preceded by transfer electrodes controlled by a second periodic transfer potential ($\phi_2$) of opposite phase with respect to the first transfer potential ($\phi_1$), under control of the output signals (s) of the M memory elements of the coefficient register (N) and in combination with the above-mentioned unit, this reading providing the output signal of the filter.

9. Filter in accordance with claim 8, characterized by the fact that, for each stage, each of the transistors ($T_B$) of the first series is connected between a third constant potential (V) and an electrode (52) of the signal register (A) which is preceded by a transfer electrode controlled by the second transfer potential ($\phi_2$), and that it receives an output signal (s) of a memory element on its gate.

10. Filter in accordance with claim 8, characterized by the fact that, for each stage, each of the transistors ($T_L$) of the second series has a common point E with a transistor ($T_{RAZ}$) of the third series, the latter ($T_{RAZ}$) being connected between the point E and the reference potential of the device and receiving such periodic potential ($\phi_{RAZ}$) on its gate that it provides for the zero reset at point E, the transistors ($T_L$) of the second series being each connected between the point E and the point D and receiving a periodic potential ($\phi_2$) on their gates which is the complement of the first mentioned potential ($\phi_{RAZ}$) so that they operate in saturation.

11. Filter in accordance with claims 3 and 8, characterized by the fact that, for each stage, the first (41) and second (40) channels of each of the memory elements are arranged perpendicularly to the transfer direction (ZZ) of the charges in the corresponding coefficient register (N); that the third channel (42) is parallel to the same direction, the paired adjacent memory elements sharing the diode ($D_3$) of the third channel; that the inversion and regeneration means (I) are formed on the same substrate as the coefficient register (N) and located in the extension of the second channel; that the corresponding transistor ($T_B$) of the first series is located in the extension of the inversion means (I); that the signal register (A) is formed on the same substrate as the coefficient register (N) and located in the neighborhood of the transistor ($T_B$) of the first series so that the charge transfer direction (ZZ) in the signal register (A) is the same as that in the coefficient register; and that the corresponding transistors of the second and third series ($T_L$ and $T_{RAZ}$) are formed on the same substrate and located in the extension of the inversion means (I) in the neighborhood of the signal register (A).

12. Filter in accordance with claims 4 and 8, characterized by the fact that it comprises an additional stage ($E_p$) representing the sign of the M coefficients, and comprising a signal register of the width $2^pL$ and a coefficient register, the multiplication and summing means further comprising a second capacity (C') of the same value as said capacity (C) and connected to the output point of this additional stage, and three signal of the filter being formed by the difference between the signal provided by this additional stage ($E_p$) and the signal provided by the p other stages ($E_0...E_{p-1}$).

13. Filter in accordance with any of claims 1 to 6, characterized by the fact that each of the signal registers ($A_0...A_{p-1}$) comprises a semiconductor substrate in which the electric charges are susceptible of being transferred by means of electrodes located on the substrate, under control of periodic potentials applied to these electrodes, the latter defining M transfer stages, termed cells, the width of these registers being the same for all of the stages ($E_0...E_{p-1}$).

14. Filter in accordance with claims 2 and 13, characterized by the fact that the multiplication and summing means comprise on the level of each stage:

— a capacity ($C_0...C_{p-1}$) the value of which is distinct for each stage and having the form

$$\frac{C_0}{2^k},$$

with $0 \leqslant k < p$, k being the weight of the coefficient bits contained in the corresponding coefficient register (N);

— three series of M transistors ($T_B$, $T_L$ and $T_{RAZ}$) which, under control of the output signals (s) of the M memory elements of the coefficient register (N) and in combination with the above-mentioned capacity, provide for the reading of the charge quantities which are respectively present beneath the M electrodes (52) of the signal register (A) which are preceded by transfer electrodes controlled by a second periodic transfer potential ($\phi_2$) of opposite phase with respect to the first transfer potential ($\phi_1$), the signals available at the terminals of the p capacities ($C_0...C_{p-1}$) being summed for providing the output signal of the filter.

15. Filter in accordance with claim 14, characterized by the fact that it comprises an additional stage ($E_p$) representing the sign of the M coefficients and comprising a signal register of the same width as the p other signal registers ($A_0...A_{p-1}$), and a coefficient register, the multiplication and summing means further comprising on the level of each additional stage ($E_p$), a capacity ($C_p$) of the value

$$\frac{C_0}{2^p}$$

and three series of M transistors ($T_B$, $T_L$ and $T_{RAZ}$), the output signal of the filter being formed by the difference between the signal provided by this additional stage ($E_p$) and the signal provided by the p other stages ($E_0...E_{p-1}$).

1/7

**FIG. 7**

**FIG. 2**

1

## FIG.3a

## FIG.3b

2

FIG.4a

FIG.4b

FIG.4c

FIG.4d

FIG.4e

FIG.5

FIG.6a

FIG.6b

FIG.6c

4

FIG.7

FIG.8a

$\phi_1$

V

0

$t_6$  $t_7$  $t_8$

t

FIG.8b

$\phi_2$

V

0

$\leftarrow T \rightarrow$

t

FIG.8c

$\varphi_2$

V

0

$t_7$  $t_8$

t

FIG.8d

$\phi_{RAZ}$

V

0

t

FIG.9